(19) Europäisches Patentamt
European Patent Office
Office européen des brevets

(11) **EP 3 004 900 B1**

(12) **FASCICULE DE BREVET EUROPEEN**

(45) Date de publication et mention de la délivrance du brevet:
**01.01.2020 Bulletin 2020/01**

(21) Numéro de dépôt: **14738543.9**

(22) Date de dépôt: **28.05.2014**

(51) Int Cl.:
*G01R 15/16* (2006.01)

(86) Numéro de dépôt international:
**PCT/FR2014/051278**

(87) Numéro de publication internationale:
**WO 2014/191695 (04.12.2014 Gazette 2014/49)**

(54) **DISPOSITIF DE MESURE DE TENSION**

SPANNUNGSMESSVORRICHTUNG

VOLTAGE MEASURING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.05.2013 FR 1354984**

(43) Date de publication de la demande:
**13.04.2016 Bulletin 2016/15**

(73) Titulaires:
• **Kapteos**
**73370 Le Bourget-du-Lac (FR)**
• **Electricité de France**
**75008 Paris (FR)**

(72) Inventeurs:
• **DUVILLARET, Lionel**
**F-73000 Chambery (FR)**
• **GABORIT, Gwenaël**
**F-73230 Saint Alban Leysse (FR)**
• **LECOCHE, Frédéric**
**F-73370 Le Bourget-du-lac (FR)**
• **SCHMITT, Gilbert**
**F-77167 Poligny (FR)**
• **GRAU, Anne**
**F-77250 Ecuelles (FR)**

(74) Mandataire: **Cabinet Beaumont**
**4, Place Robert Schuman**
**B.P. 1529**
**38025 Grenoble Cedex 1 (FR)**

(56) Documents cités:
**WO-A1-00/34793      US-A- 5 473 244**

• **MITCHELL N: "Stability Criteria for Cable-in-Conduit Superconducting Cables for Steady or Slow Pulse Operation", IEEE TRANSACTIONS ON APPLIED SUPERCONDUCTIVITY, IEEE SERVICE CENTER, LOS ALAMITOS, CA, US, vol. 14, no. 2, 1 juin 2004 (2004-06-01), pages 1350-1355, XP011117598, ISSN: 1051-8223, DOI: 10.1109/TASC.2004.830576**

**Description**

La présente demande de brevet revendique la priorité de la demande de brevet français FR13/54984.

Domaine

La présente invention concerne un dispositif et un procédé de mesure de tension, et plus particulièrement un dispositif et un procédé de mesure de tension dans un câble d'alimentation.

Exposé de l'art antérieur

Un câble d'alimentation électrique comprend, de façon générale, au moins un fil conducteur, également appelé conducteur, par exemple trois fils conducteurs. Chaque fil conducteur peut être entouré d'une gaine isolante, et les fils conducteurs avec leurs gaines isolantes sont maintenus ensemble dans un manchon isolant. A titre de variante, les fils conducteurs peuvent être noyés dans une seule gaine isolante.
A titre d'exemple, dans un câble d'alimentation en courant triphasé, les fils conducteurs transportent des courants sinusoïdaux ayant la même amplitude maximale et la même fréquence, les phases des courants étant décalées d'un fil conducteur à l'autre, par exemple de 120°. A titre d'exemple, pour une application industrielle, la tension efficace dans chaque fil conducteur peut être de l'ordre de 300 à 400 V.
Il peut être souhaitable de mesurer la tension dans chaque conducteur d'un câble d'alimentation électrique par exemple pour déterminer si les valeurs des tensions efficaces et l'équilibrage des phases sont conformes. Toutefois, les dispositifs de mesure de tension actuels nécessitent d'exposer chaque conducteur du câble et de connecter un voltmètre à chaque conducteur exposé.
Il serait donc souhaitable de pouvoir mesurer les tensions des conducteurs d'un câble d'alimentation électrique en laissant les conducteurs dans leur gaine isolante.
Les documents suivants font partie de l'état de la technique pertinent : WO 00/34793 A1, US 5 473 244 A et XP011117598 (Mitchell N.: "Stability Criteria for Cable-in-Conduit Superconducting Cables for Steady or Slow Pulse Opération").

Résumé

Un objet d'un mode de réalisation vise à proposer un dispositif et un procédé de mesure de tension qui pallie tout ou partie des inconvénients des dispositifs de mesure de tension usuels.
Selon un autre objet d'un mode de réalisation, les mesures des tensions des conducteurs du câble d'alimentation peuvent être réalisées sans retrait des gaines isolantes entourant les conducteurs.
Selon un autre objet d'un mode de réalisation, le procédé de mesure de tension peut être mis en oeuvre sans connaître le nombre de conducteurs du câble.
Selon un autre objet d'un mode de réalisation, la structure du dispositif de mesure de tension est simple.
Ainsi, un mode de réalisation de la présente invention prévoit un procédé de mesure de la tension d'au moins un conducteur d'un câble d'alimentation électrique comprenant les étapes suivantes :

disposer une enceinte d'un matériau conducteur autour d'une portion du câble et au moins un capteur de champ électrique entre l'enceinte et le câble ;
amener l'enceinte à un potentiel constant et mesurer le champ électrique par le capteur ; et
déterminer ladite tension à partir de la comparaison du champ électrique mesuré à des champs électriques simulés pour plusieurs configurations de charges électriques ponctuelles.
Selon un mode de réalisation, le procédé comprend, en outre, les étapes suivantes :

déterminer par simulation le champ électrique obtenu à l'emplacement dudit capteur pour plusieurs configurations de charges électriques ponctuelles correspondant à des positions différentes des charges électriques ponctuelles ;
déterminer un critère de comparaison entre le champ électrique mesuré et le champ électrique simulé pour chaque configuration ; et
mémoriser la configuration pour laquelle le critère de comparaison est à un extrémum.

Selon un mode de réalisation, le procédé comprend la détermination par simulation du champ électrique obtenu à l'emplacement dudit capteur pour chaque configuration d'un premier ensemble de configurations ayant un premier nombre de charges électriques ponctuelles et pour chaque configuration d'un deuxième ensemble de configurations ayant un deuxième nombre de charges électriques ponctuelles différent du premier nombre.

Selon un mode de réalisation, le procédé comprend les étapes suivantes :

sélectionner au moins un paramètre parmi le groupe comprenant la position du centre du conducteur par rapport au centre du câble, le rayon moyen du conducteur, la position angulaire du conducteur par rapport à un axe de référence, la phase de la tension du conducteur et l'amplitude maximale de la tension du conducteur ;
faire varier le paramètre entre une valeur initiale et une valeur finale avec un pas ; et
déterminer le champ électrique obtenu à l'emplacement dudit capteur pour chaque configuration de charges électriques ponctuelles associée à chaque valeur du paramètre.

Selon un mode de réalisation, le procédé comprend les étapes suivantes :

(a) déterminer le nombre de conducteurs du câble à partir de la comparaison du champ électrique mesuré aux champs électriques simulés pour des configurations de charges électriques ponctuelles comprenant des nombres différents de charges électriques ponctuelles ; et
(b) déterminer ladite tension à partir de la comparaison du champ électrique mesuré aux champs électriques simulés pour plusieurs configurations ayant le même nombre de charges électriques ponctuelles.

Selon un mode de réalisation, l'étape (a) est réalisée en faisant varier, simultanément pour chaque conducteur, au moins un premier paramètre parmi ledit groupe et l'étape (b) est réalisée en faisant varier, indépendamment pour chaque conducteur, au moins un deuxième paramètre parmi ledit groupe.

Un mode de réalisation prévoit également un dispositif de mesure de la tension d'au moins un conducteur d'un câble d'alimentation électrique comprenant :

une enceinte d'un matériau conducteur destinée à être disposée autour d'une portion du câble et au moins un capteur de champ électrique destiné à être disposé entre l'enceinte et le câble ;
une source d'un potentiel constant reliée à l'enceinte ; et
un module de traitement adapté à déterminer ladite tension à partir de la comparaison du champ électrique mesuré aux champs électriques simulés pour plusieurs configurations de charges électriques ponctuelles.

Selon un mode de réalisation, le dispositif comprend plusieurs capteurs de champ électrique.

Selon un mode de réalisation, les capteurs sont maintenus dans un support tubulaire d'un matériau diélectrique.

Selon un mode de réalisation, le dispositif comprend au moins un capteur optique mesurant le champ électrique comprenant un cristal électro-optique isotrope.

Brève description des dessins

Ces caractéristiques et avantages, ainsi que d'autres, sont exposés en détail dans la description suivante de modes de réalisation particuliers faite à titre non limitatif en relation avec les figures jointes parmi lesquelles :

la figure 1 est une vue en écorché d'un câble d'alimentation électrique ;
les figures 2 et 3 sont des coupes dans deux plans orthogonaux d'un mode de réalisation d'un dispositif de mesure de tension d'un câble d'alimentation ;
la figure 4 illustre des paramètres déterminés par le dispositif de mesure de tension ;
la figure 5 représente, sous la forme d'un schéma-bloc, un mode de réalisation d'un procédé de mesure de tension ;
la figure 6 représente un exemple de mesures de champs électriques par le dispositif de mesure de tension selon le mode de réalisation des figures 2 et 3 ;
les figures 7 à 10 représentent différentes structures de câbles d'alimentation électrique et les modèles électriques équivalents mis en oeuvre par le mode de réalisation du procédé de mesure de tension illustré en figure 5 ; et
la figure 11 représente un exemple de simulations de champs électriques mis en oeuvre par le mode de réalisation du procédé de mesure de tension illustré en figure 5.

Description détaillée

Par souci de clarté, de mêmes éléments ont été désignés par de mêmes références aux différentes figures et, de plus, les diverses figures ne sont pas tracées à l'échelle. Dans la suite de la description, sauf indication contraire, les termes "sensiblement", "environ", "approximativement" et "de l'ordre de" signifient "à 10 % près".

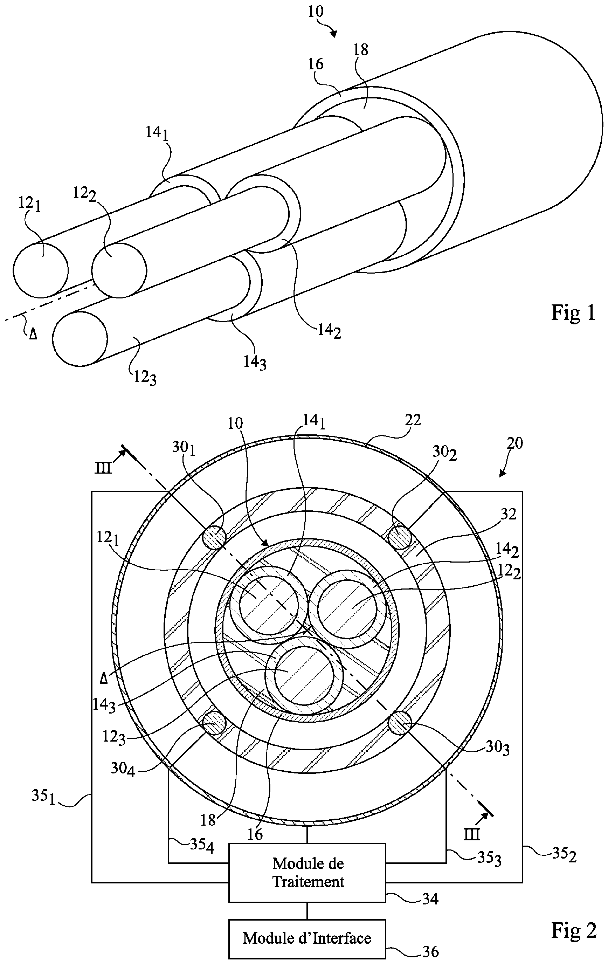

La figure 1 représente un exemple de câble d'alimentation 10 d'axe Δ. Le câble 10 comprend N conducteurs

$12_i$, N étant un nombre entier supérieur ou égal à 1, par exemple variant de 1 à 10, de préférence de 1 à 5, et i étant un nombre entier variant de 1 à N. Dans l'exemple représenté en figure 1, N est égal à trois. Chaque conducteur $12_i$, constitué d'un matériau métallique, notamment à base de cuivre ou d'aluminium, peut correspondre à un fil unique ou à un ensemble de brins. Chaque conducteur $12_i$ est entouré d'une gaine $14_i$ d'un matériau diélectrique. Les trois conducteurs 12 sont maintenus dans un manchon isolant 16, l'espace entre le manchon 16 et les gaines $14_i$ pouvant être rempli d'un matériau de remplissage 18 isolant. Les matériaux isolants constituant les gaines $14_i$, le manchon 16 ou le matériau de remplissage 18 peuvent être identiques ou différents.

A titre d'exemple, chaque conducteur $12_i$ a une section droite circulaire ou elliptique. Toutefois, chaque conducteur $12_i$ peut avoir une section droite de forme plus complexe, par exemple une forme de secteur angulaire ou une forme initialement circulaire qui a été plus ou moins écrasée. Les sections droites des conducteurs $12_i$ peuvent être identiques ou différentes.

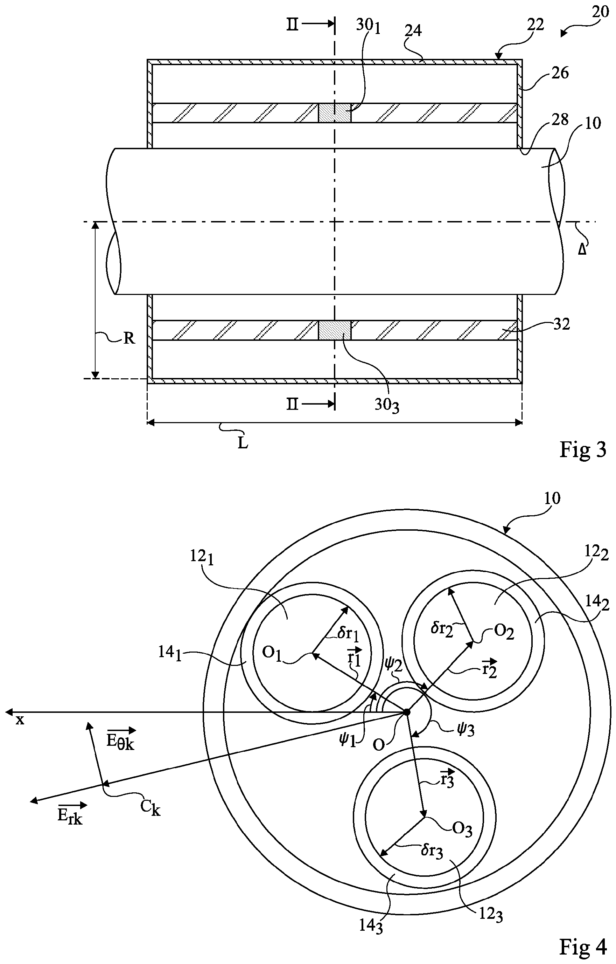

Les figures 2 et 3 représentent un mode de réalisation d'un dispositif de mesure 20 des tensions dans les conducteurs $12_i$ du câble d'alimentation 10.

Le dispositif 20 comprend une enceinte 22, constituée d'un matériau conducteur, par exemple du maillechort, et comprenant une portion 24 cylindrique d'axe $\Delta$ fermée aux extrémités par des portions annulaires 26. La paroi interne de la portion cylindrique 24 correspond à un cylindre d'axe $\Delta$ et de rayon R. La longueur L mesurée selon l'axe $\Delta$ est, de préférence, strictement supérieure à R. Chaque portion annulaire 26 comprend une ouverture cylindrique 28 d'axe $\Delta$ pour le passage du câble 10.

Le dispositif 20 comprend M capteurs $30_k$ de champ électrique où M est un nombre entier supérieur ou égal à 1, par exemple variant de 1 à 8, et k est un nombre entier variant de 1 à M. A titre d'exemple, en figure 2, M est égal à quatre. De préférence, les capteurs $30_k$ sont disposés dans un plan perpendiculaire à l'axe $\Delta$. A titre d'exemple, les capteurs $30_k$ sont disposés sur un cercle d'axe $\Delta$. Les capteurs $30_k$ sont maintenus par un support 32, constitué d'un matériau diélectrique. A titre d'exemple, le support 32 correspond à un tube d'axe $\Delta$, fixé à l'enceinte 20 à ses extrémités et dans la paroi duquel sont fixés les capteurs $30_k$.

Le dispositif 20 comprend, en outre, un module de traitement 34, représenté seulement en figure 2, qui est relié à chaque capteur $30_k$. Le module de traitement 34 comprend, par exemple, un processeur et peut correspondre à un ordinateur. Le module de traitement 34 peut, en outre, comprendre une mémoire non volatile dans laquelle est stockée une suite d'instructions qui commandent le fonctionnement du module de traitement 34. A titre de variante, le module de traitement 34 peut être réalisé par un circuit électronique dédié.

Le module de traitement 34 est relié à chaque capteur $30_k$, k variant de 1 à M, par un ou plus d'un fil électrique et/ou par une ou plus d'une fibre optique $35_k$. Le module de traitement 34 est relié à un module d'interface 36, comprenant par exemple un écran d'affichage, un clavier, une souris, etc.

Le dispositif 20 permet le maintien en position du câble 10 par rapport aux capteurs $30_k$ et par rapport à la portion cylindrique 24. Selon une variante, une pièce intermédiaire peut être disposée à l'intérieur du support 32 et entre les ouvertures 28 pour s'adapter à des câbles d'alimentation 10 de diamètres différents. Selon une autre variante, le maintien du câble 10 n'est pas réalisé par l'enceinte 20 mais par un moyen supplémentaire qui, lorsque le dispositif 20 est mis en place sur le câble 10, permet de maintenir constant l'écartement entre le câble 10 et les capteurs $30_k$ et entre le câble 10 et la portion cylindrique 24.

L'enceinte 22 peut être constituée de deux demi-enceintes mobiles l'une par rapport à l'autre et le support 32 peut être constitué de deux demi-supports, chaque demi-support étant relié à l'une des demi-enceintes. Les deux demi-enceintes sont, par exemple, reliées l'une à l'autre par une liaison à charnières. Le montage du dispositif de mesure 20 sur le câble 10 peut alors être réalisé en prenant le câble 10 en sandwich entre les deux demi-enceintes qui sont temporairement fixées l'une à l'autre.

Selon un mode de réalisation, au moins l'un des capteurs $30_k$ comprend un capteur optique tel que décrit dans la demande de brevet US 8 264 685.

Selon un autre mode de réalisation, au moins l'un des capteurs $30_k$ comprend un microsystème électroméca-nique tel que décrit dans la publication intitulée "Electric field sensor using electrostatic force deflection of a micro-spring supported membrane" aux noms de A. Roncin, C. Shafai et D.R. Swatek ou dans la publication intitulée "A Self-Resonant MEMS-based Electrostatic Field Sensor with 4V/m/$\sqrt{Hz}$ Sensitivity" aux noms de T. Denison, J. Kuang, J. Shafran, M. Judy et K. Lundberg.

Selon un mode de réalisation, le capteur $30_k$ est un capteur optique comprenant un cristal électro-optique. L'épaisseur du cristal électro-optique, mesurée selon une direction parallèle à l'axe $\Delta$, peut varier de 0,2 à 10 millimètres, de préférence de 1 à 5 millimètres. A titre d'exemple, le cristal est un cristal électro-optique isotrope. Un cristal électro-optique isotrope est un cristal dont les propriétés optiques sont isotropes en l'absence de champ électrique et dont les propriétés optiques sont anisotropes en présence d'un champ électrique. Le cristal peut être du tellure de zinc (ZnTe), du tellure de cadmium (CdTe), du tellure de cadmium et de zinc ($Cd_{1-x}Zn_xTe$) (avec x pouvant varier de 0,01 à 0,15), de l'oxyde de bismuth et de silicium (BSO), de l'arséniure de gallium (AsGa) ou du phosphure d'indium (InP).

L'épaisseur du support 32 peut être sensiblement égale à l'épaisseur du capteur $30_k$. A titre de variante, l'épaisseur du support 32 peut être supérieure à l'épaisseur du capteur $30_k$, le capteur $30_k$ étant alors noyé dans le support 32. La permittivité relative du matériau constituant le support 32 est sensiblement égale à la permittivité relative du capteur $30_k$. A titre d'exemple, lorsque le capteur $30_k$ correspond à un cristal électro-optique, le cristal électro-optique et le matériau 32 ont une permittivité relative pouvant varier de 4 à 60, de préférence de 7 à 15. Le matériau constituant le support 32 peut être une résine comprenant une charge permettant d'ajuster la permittivité relative du support 32.

Lorsque le capteur $30_k$ correspond à un capteur optique comprenant un cristal électro-optique, le module de traitement 34 peut comprendre un système d'émission d'un faisceau lumineux vers le cristal électro-optique et un système d'analyse du faisceau lumineux issu du cristal électro-optique. Les faisceaux lumineux peuvent être transportés entre le cristal et le module de traitement par les fibres optiques $35_k$.

Lorsque le capteur $30_k$ correspond à un capteur optique, son principe de fonctionnement peut être le suivant. Le champ électrique présent au niveau du cristal électro-optique fait varier certaines propriétés optiques du cristal. Le faisceau lumineux traversant le cristal est donc modifié. La modification du faisceau lumineux est détectée par le module de traitement 34 qui fournit des signaux représentatifs des amplitudes des composantes du champ électrique mesurées.

A titre d'exemple, les dimensions du dispositif de mesure 20 sont :

diamètre intérieur de la portion cylindrique 24 de l'enceinte 20 : 69 mm ;
épaisseur de la portion cylindrique 24 : 0,5 mm ;
diamètre de l'ouverture 28 : 30 mm ;
longueur axiale de la portion cylindrique 24 : 100 mm ;
diamètre intérieur du support 20 : 30 mm ; et
diamètre extérieur du support 20 : 70 mm.

Dans le présent mode de réalisation, les capteurs $30_k$ sont fixes par rapport à l'enceinte 22. A titre de variante, le dispositif 20 peut ne comprendre qu'un seul capteur de champ électrique, ou un nombre réduit de capteurs de champ électrique, et comprendre, en outre, un système pour déplacer les capteurs de champ électrique par rapport au câble 10 et/ou à l'enceinte 22. Il peut s'agir d'un système pour faire pivoter le capteur de champ électrique autour du câble 10 selon un cercle d'axe $\Delta$.

La figure 4 est une coupe dans un plan perpendiculaire à l'axe $\Delta$ du câble 10 et illustre certains paramètres pris en compte pour la mise en oeuvre d'un mode de réalisation du procédé de mesure de tensions. Le plan de coupe de la figure 4 est appelé plan de mesure dans la suite de la description.

Le point O correspond au point d'intersection entre l'axe $\Delta$ du câble 10 et le plan de coupe de la figure 4. Le point O peut correspondre au centre géométrique de la section droite du câble 10, notamment au centre de symétrie de la section droite lorsque le câble 10 a une section droite circulaire, elliptique, rectangulaire, etc. L'axe (Ox) correspond à un axe de référence. Dans le plan de mesure, chaque conducteur $12_i$ comprend un centre $O_i$. Le centre $O_i$ correspond au centre géométrique du conducteur $12_i$, notamment au centre de symétrie de la section droite lorsque le conducteur $12_i$ a une section droite circulaire, elliptique, rectangulaire, etc. En outre, dans le plan de mesure, la section droite de chaque conducteur $12_i$ occupe une surface $S_i$. Dans le cas où le conducteur $12_i$ a une section circulaire, la surface $S_i$ est un disque et le point $O_i$ correspond au centre du disque. On appelle $\vec{r}_i$ le vecteur reliant le point O au point $O_i$ et $\Psi_i$ l'angle, mesuré dans le sens horaire, entre l'axe (Ox) et le vecteur $\vec{r}_i$. En outre, on appelle $\delta r_i$ le rayon moyen du conducteur $12_i$. Le rayon moyen $\delta r_i$ correspond au rayon du conducteur $12_i$ dans le cas où le conducteur $12_i$ a une section circulaire et correspond au rayon du disque ayant la même surface que le conducteur $12_i$ lorsque le conducteur $12_i$ a une section droite non circulaire.

Lorsque des tensions sont appliquées aux conducteurs $12_i$ du câble d'alimentation 10, ceci se traduit par l'apparition d'un champ électrique $\vec{E}$ en tout point de l'espace autour du câble 10, ce champ électrique étant variable dans le temps dans le cas de tensions variables. Chaque capteur $30_k$ est adapté à mesurer l'amplitude du vecteur champ électrique $\vec{E}_k$ à l'emplacement du capteur $30_k$ désigné, de façon schématique, par le point $C_k$. Le plan de mesure comprend l'ensemble des points $C_k$, k variant de 1 à M, un seul point $C_k$ étant représenté en figure 4.

Plus précisément, chaque capteur $30_k$ est adapté à mesurer l'amplitude de la composante radiale $\vec{E}_{rk}$ du champ électrique à l'emplacement du capteur $30_k$ et l'amplitude de la composante tangentielle $\vec{E}_{\theta k}$ du champ électrique à l'emplacement du capteur $30_k$. La composante radiale $\vec{E}_{rk}$ est la composante du champ électrique orientée selon la droite $(OC_k)$. La composante tangentielle $\vec{E}_{\theta k}$ est la composante du champ électrique orientée selon la droite perpendiculaire à la droite $(OC_k)$ dans le plan de coupe de la figure 4 et passant par le point $C_k$. Dans la suite de la description, on néglige la composante du champ électrique $\vec{E}_k$ selon l'axe $\Delta$, cette composante pouvant être négligée dès que la torsion des conducteurs internes présente un pas d'hélice grand devant la distance moyenne entre le point O et le centre des conducteurs $O_i$.

Selon un mode de réalisation, pour déterminer la tension dans chaque conducteur $12_i$ sans contact avec les conducteurs $12_i$, le module de traitement 34 doit déterminer la tension $V_i$ dans chaque conducteur $12_i$ à partir des mesures des champs électriques $\vec{E}_k$.

Les tensions $V_i$ dans les conducteurs $12_i$, i variant de 1 à N, ne peuvent pas être déterminées directement. Il faut d'abord déterminer la charge électrique $Q_i$ dans chaque conducteur $12_i$ dans le plan de mesure, puis déterminer les tensions $V_i$ à partir des charges $Q_i$.

La détermination des charges $Q_i$ à partir des mesures des champs électriques $\vec{E}_k$ peut, de façon théorique, être réalisée en utilisant le théorème de Gauss qui s'écrit selon la relation (1) suivante :

$$\oiint_S \vec{E}.\overrightarrow{d^2S} = \frac{Q_{int}}{\varepsilon_0\varepsilon_r} \qquad (1)$$

où S est une surface fermée, $Q_{int}$ est la charge électrique à l'intérieur de la surface S, $\varepsilon_0$ est la permittivité du vide et $\varepsilon_r$ est la permittivité relative du milieu au niveau de la surface S.

En outre, le principe de superposition prévoit que le champ électrique $\vec{E}_k$ au point $C_k$ est égal à la somme des champs électriques dus à chaque charge $Q_i$ considérée isolément et distribuée sur la surface $S_i$ de chaque conducteur $12_i$.

Pour un câble d'alimentation électrique, la tension $V_i$ peut être recherchée selon la relation (2) suivante :

$$V_i = A_i \cos(\omega t + \varphi_i) \qquad (2)$$

où $A_i$ est l'amplitude de la tension $V_i$, $\omega$ est la pulsation de la tension $V_i$ et $\varphi_i$ est la phase de la tension $V_i$. Dans la suite de la description, on appelle T la période de la tension $V_i$. La période T est égale à $2\pi/\omega$.

On peut alors considérer que la charge linéique $Q_i$ dans le conducteur $12_i$ est proportionnelle à la tension $V_i$ selon un facteur de proportionnalité $F_i$ qui dépend notamment des formes des conducteurs $12_i$, des positions relatives entre les conducteurs $12_i$, et des permittivités des matériaux diélectriques présents dans le câble 10. Lorsque les conducteurs $12_i$ sont sensiblement identiques et disposés de façon régulière, les facteurs de proportionnalité $F_i$ peuvent être identiques et égaux à un facteur de proportionnalité F.

En pratique, la résolution des équations indiquées précédemment pour parvenir à la détermination des charges $Q_i$ ne peut pas être mise en oeuvre de façon simple en temps réel par ordinateur puisque de nombreux paramètres ne sont pas connus. En effet, la forme exacte de la surface $S_i$ de chaque conducteur $12_i$, la position du centre $O_i$ de chaque conducteur $12_i$ et l'environnement du câble 10 ne sont pas connus au moment de la mesure. Or l'environnement du câble 10, de par la présence d'autres conducteurs ou de surfaces équipotentielles de formes quelconques, peut modifier de façon importante la répartition du champ électrique au niveau des capteurs $30_k$. En outre, le nombre N de conducteurs $12_i$ peut ne pas être connu au moment de la mesure.

Les inventeurs ont mis en évidence que, lorsqu'une enceinte cylindrique est disposée autour du câble d'alimentation de façon coaxiale au câble et lorsque cette enceinte est mise à un potentiel de référence, par exemple la masse, le champ électrique $\vec{E}$ présent entre l'enceinte et le câble, qui résulte des contributions de l'enceinte et des conducteurs du câble, est sensiblement identique au champ électrique dû à des charges électriques ponctuelles positives et négatives, les positions et les valeurs de ces charges ponctuelles dépendant notamment du nombre de conducteurs, de leurs positions et de leurs formes. En outre, la répartition du champ électrique au niveau des capteurs $30_k$ ne dépend plus de l'environnement extérieur au dispositif 20. Un procédé de détermination de positions et de valeurs de charges électriques ponctuelles à partir des équations indiquées précédemment peut être mis en oeuvre en temps réel par ordinateur ou au moyen d'un simple calculateur embarqué.

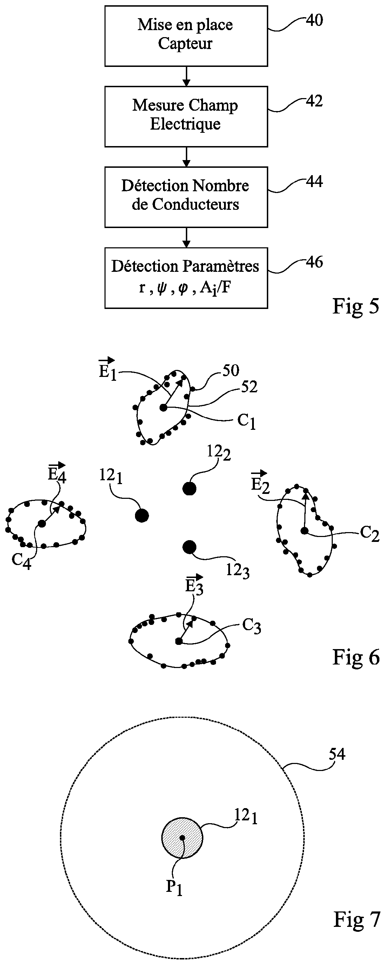

La figure 5 représente, sous la forme d'un schéma-bloc, un mode de réalisation d'un procédé de mesure de tensions. Le procédé comprend des étapes successives 40, 42, 44 et 46.

A l'étape 40, le dispositif de mesure 20 est mis en place autour du câble 10 et l'enceinte 22 du dispositif de mesure 20 est amenée à un potentiel de référence, par exemple la masse.

A l'étape 42, le module de traitement 34 mesure l'amplitude de la composante radiale $\vec{E}_{rk}$ et l'amplitude de la composante tangentielle $\vec{E}_{\theta k}$ du champ électrique $\vec{E}_k$ à l'emplacement de chaque capteur $30_k$, k variant de 1 à M. Plusieurs mesures, par exemple plus de vingt mesures, sont réalisées sur une période T d'oscillation des tensions $V_i$.

La figure 6 représente un exemple de mesures de champs électriques par quatre capteurs pour un câble d'alimentation comprenant trois conducteurs $12_1$, $12_2$ et $12_3$. En figure 6, on a représenté les centres $C_1$, $C_2$, $C_3$ et $C_4$ des capteurs et les positions 50 de l'extrémité du vecteur champ électrique $\vec{E}_k$ appliqué au centre $C_k$ aux instants de mesure pendant une période T. On a, en outre, représenté la courbe 52 d'évolution de la position de l'extrémité du

vecteur champ électrique $\vec{E}_k$ obtenue par interpolation. Comme cela apparaît sur la figure 6, l'extrémité de chaque champ électrique $\vec{E}_k$ suit une courbe dont la forme générale est proche d'une ellipse.

Aux étapes 44 et 46, le module de traitement 34 utilise des modèles électriques équivalents à l'ensemble constitué par les conducteurs $12_i$ et l'enceinte 22.

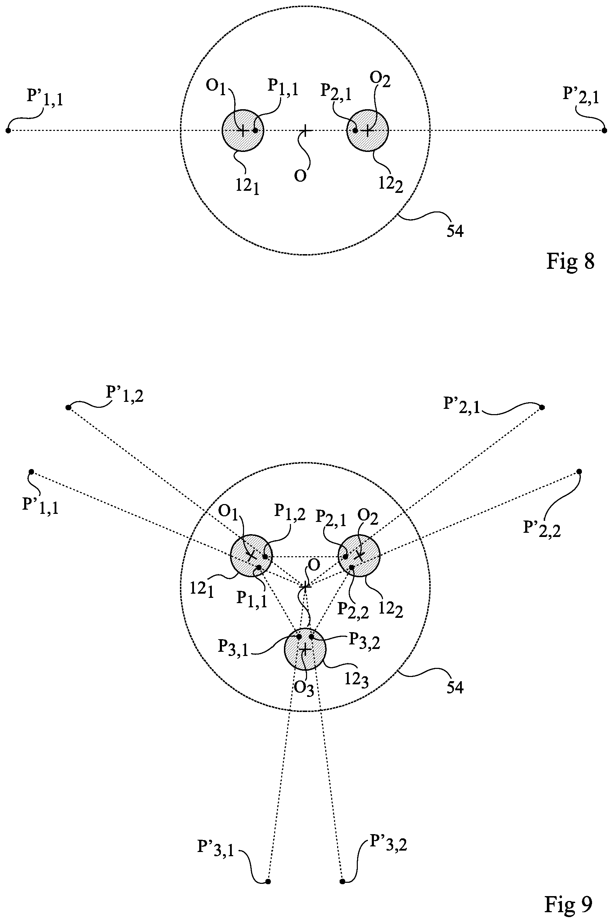

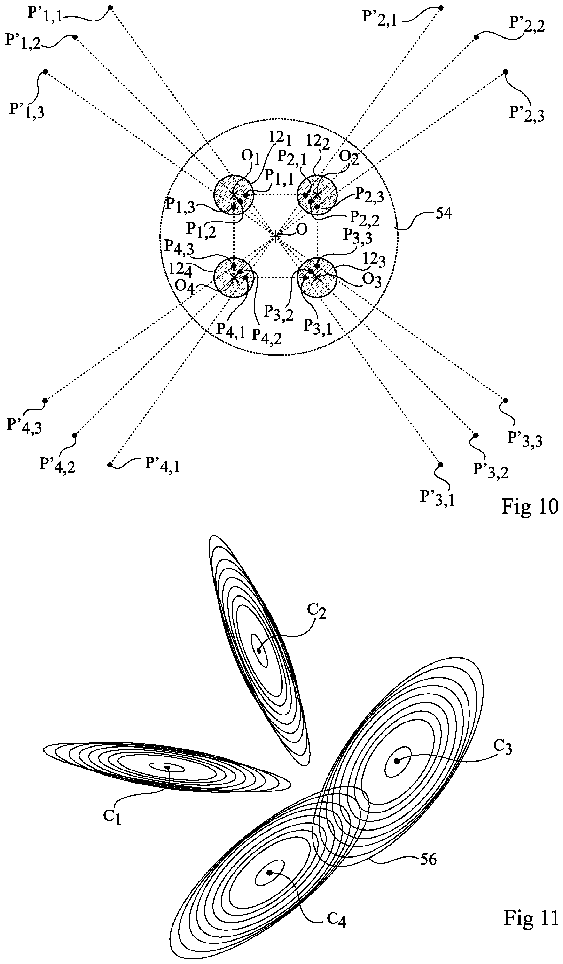

Les figures 7 à 10 représentent les conducteurs $12_i$ par des cercles hachurés, respectivement pour un câble 10 comprenant un seul conducteur $12_1$ (figure 7), deux conducteurs $12_1$ et $12_2$ (figure 8), trois conducteurs $12_1$, $12_2$ et $12_3$ (figure 9) et quatre conducteurs $12_1$, $12_2$, $12_3$ et $12_4$ (figure 10). L'enceinte 22 du dispositif de mesure 20 est, en outre, représenté par un cercle 54 en traits pointillés de rayon R sur ces figures. Chaque figure 7 à 10 représente, en outre, le modèle électrique à base de charges électriques ponctuelles qui est équivalent à l'ensemble comprenant les conducteurs $12_i$ et l'enceinte 22 maintenue à un potentiel de référence.

En figure 7, lorsque le câble 10 comprend un seul conducteur $12_1$, le modèle électrique équivalent comprend une seule charge électrique ponctuelle $P_1$, ayant la charge électrique $Q_1$, placée au centre $O_1$ du conducteur $12_1$. De façon plus générale, pour un câble électrique 10 comprenant N conducteurs avec N strictement supérieur à 1, le modèle électrique équivalent à l'ensemble comprenant les conducteurs électriques $12_i$ et l'enceinte 22 maintenue à un potentiel de référence comprend un nombre 2N(N-1) de charges ponctuelles. Plus précisément, à chaque conducteur électrique $12_i$, pour i variant de 1 à N, sont associées N-1 charges ponctuelles $P_{i,u}$ et N-1 charges ponctuelles images $P'_{i,u}$ où u est un nombre entier variant de 1 à N-1. Chaque charge ponctuelle $P_{i,u}$ a une charge électrique égale à une fraction de $Q_i$, la somme des charges électriques $P_{i,u}$ associées à un même conducteur électrique $12_i$ valant $Q_i$. Chaque charge ponctuelle image $P'_{i,u}$ a une charge électrique égale, en valeur absolue, à la charge électrique $P_{i,u}$ et de signe opposé.

Les charges ponctuelles sont disposées de façon que la courbe 54 corresponde à une équipotentielle. Les figures 7 à 10 illustrent les principes de détermination des positions des charges ponctuelles. En particulier, certaines charges ponctuelles sont placées sur les droites reliant les centres de conducteurs adjacents. En outre, par rapport à la charge ponctuelle $P_{i,u}$, la charge ponctuelle image $P'_{i,u}$ est disposée de façon que la distance $OP'_{i,u}$ vérifie la relation (3) suivante :

$$OP'_{i,u} = \frac{R^2}{OP_{i,u}} \qquad (3)$$

A l'étape 44, le module de traitement 34 détermine le nombre N de conducteurs $12_i$ du câble lorsque ce nombre n'est pas connu. Le module de traitement 34 utilise successivement le modèle électrique équivalent à un seul conducteur, le modèle électrique équivalent à deux conducteurs, le modèle électrique équivalent à trois conducteurs, etc.

En outre, des conditions liant les paramètres des modèles électriques équivalents sont utilisées pour simplifier les calculs. Il est notamment considéré que :

(i) les conducteurs $12_i$ sont identiques, de section circulaire et de même rayon $\delta r$ ;
(ii) les centres $O_i$ des conducteurs sont à la même distance r du centre O ;
(iii) les conducteurs $12_i$ sont répartis régulièrement autour du centre O du câble 10 ;
(iv) les amplitudes $F*A_i$ sont identiques ;
(v) les phases $\varphi_i$ sont liées par une relation qui dépend du nombre de conducteurs $12_i$ ; et
(vi) lorsque le câble 10 comprend plus de quatre conducteurs $12_i$, le potentiel d'au moins l'un des conducteurs est constant et mis à 0 V.

La condition (i) signifie notamment que les facteurs de pondération $F_i$ sont identiques et égaux à F. La condition (iii) signifie, notamment dans le cas d'un câble 10 comprenant deux conducteurs $12_1$ et $12_2$, que ces conducteurs sont disposés de façon symétrique par rapport au centre O et, dans le cas d'un câble 10 comprenant trois conducteurs $12_1$, $12_2$ et $12_3$, que ces conducteurs sont disposés à 120° les uns par rapport aux autres autour du centre O et à même distance du centre O. La condition (v) signifie, par exemple, que, dans le cas d'un câble à trois conducteurs $12_1$, $12_2$ et $12_3$, les phases $\varphi_1$, $\varphi_2$ et $\varphi_3$ sont décalées les unes par rapport aux autres de 120°.

Pour chaque modèle électrique équivalent, le module de traitement 34 fait varier indépendamment les paramètres suivants entre une valeur initiale et une valeur finale avec un pas d'incrémentation :

la distance r ;
l'angle $\Psi_1$ ; et
l'amplitude $F*A_1$.

Dans chaque configuration obtenue, le module de traitement 34 détermine la courbe d'évolution du champ électrique obtenu aux centres $C_k$, k variant de 1 à M, de chaque capteur au cours d'une période T. Le module de traitement 34 compare alors la courbe simulée obtenue pour le capteur $30_k$ avec la courbe mesurée à l'étape 42 pour le capteur $30_k$ et détermine un critère de comparaison pour la configuration. A titre d'exemple, le module de traitement 34 détermine, pour chaque capteur $30_k$, l'erreur quadratique moyenne entre la courbe mesurée et la courbe simulée ou d'autres critères comme l'erreur absolue moyenne, l'erreur quadratique relative moyenne ou encore le coefficient de corrélation de Pearson. Le critère de comparaison pour la configuration est, par exemple, égal à la somme des erreurs quadratique moyenne pour chaque capteur.

Le module de traitement 34 détermine que le nombre N de conducteurs du câble 10 est le nombre de conducteurs de la configuration pour laquelle le critère de comparaison est minimal. Il s'agit de la configuration pour laquelle les courbes mesurées sont les plus proches des courbes simulées.

Le module de traitement 34 conserve dans une mémoire les valeurs des paramètres r, $\Psi_1$ et $F^*A_1$ pour lesquelles le critère de comparaison est minimal. Ces valeurs sont notées respectivement $r_{INI}$, $\Psi_{INI1}$ et $F^*A_{INI1}$. En outre, dans le cas représenté sur la figure 4, la valeur $\Psi_{INI1}$ fixe les valeurs $\Psi_{INI2}$ et $\Psi_{INI3}$.

A l'étape 44, si le nombre N de conducteurs $12_i$ du câble 10 est déjà connu, l'opérateur réalisant la mesure peut indiquer ce nombre N au module de traitement 34 par l'intermédiaire du module d'interface 36. Le module de traitement 34 peut alors ne faire varier indépendamment les paramètres r, $\Psi_1$ et $F^*A_1$ que pour le modèle électrique équivalent correspondant au nombre N connu de conducteurs.

A l'étape 46, le module de traitement 34 utilise la configuration déterminée à l'étape 44 pour laquelle le critère de comparaison est minimal.

Le module de traitement 34 modifie le modèle électrique équivalent de cette configuration en faisant varier indépendamment les paramètres suivants, pour chaque conducteur $12_i$, entre une valeur initiale et une valeur finale avec un pas d'incrémentation :

la distance $r_i$ ;
l'angle $\Psi_i$;
le rayon $\delta r_i$ ;
l'amplitude $F^*A_i$ ; et
la phase $\varphi_i$.

A titre de variante, pour certains des paramètres indiqués précédemment, notamment le rayon $\delta r_i$, le paramètre peut être modifié de façon simultanée, et éventuellement identique, pour tous les conducteurs $12_i$.

A titre d'exemple, en relation avec l'exemple représenté en figure 4, le module de traitement 34 peut faire varier, indépendamment pour chaque conducteur, les paramètres $r_i$, $F^*A_i$, $\Psi_1$, $\Psi_2$, $\Psi_3$ respectivement autour des valeurs $r_{INI}$, $F^*A_{INI1}$, $\Psi_{INI1}$, $\Psi_{INI2}$ et $\Psi_{INI3}$ déterminées à l'étape 44.

Dans chaque configuration obtenue, le module de traitement 34 détermine la courbe d'évolution du champ électrique obtenu aux centres $C_k$, k variant de 1 à M, de chaque capteur au cours d'une période T.

La figure 11 représente un exemple de simulations des champs électriques $\vec{E}_k$ aux centres $C_1$, $C_2$, $C_3$ et $C_4$ de quatre capteurs pour un câble 10 comprenant trois conducteurs. En figure 6, on a représenté les courbes 56 suivies par l'extrémité du vecteur champ électrique $\vec{E}_k$ appliqué au centre $C_k$ pendant une période T pour des valeurs du paramètre $\delta r_i/r_i$ variant entre 0,1 et 0,8 pour i variant de 1 à 3.

Le module de traitement 14 compare alors la courbe simulée obtenue pour le capteur $30_k$ avec la courbe mesurée à l'étape 42 pour le capteur $30_k$ et détermine un critère de comparaison pour la configuration. A titre d'exemple, le module de traitement 14 détermine pour chaque capteur $30_k$ l'erreur quadratique moyenne entre la courbe mesurée et la courbe simulée. Le critère de comparaison pour la configuration est, par exemple, égal à la somme des erreurs quadratique moyenne pour chaque capteur.

Le module de traitement 34 conserve dans une mémoire les valeurs, pour chaque conducteur $12_i$, i variant de 1 à N, des paramètres $r_i$, $\Psi_i$, $\delta r_i$, $F^*A_i$ et $\varphi_i$ pour lesquelles le critère de comparaison est minimal. Ces valeurs sont notées respectivement $r_{FINi}$, $\Psi_{FINi}$, $\delta r_{FINi}$, $F^*A_{FINi}$ et $\varphi_{FINi}$. Le module de traitement 34 peut alors fournir à l'opérateur, par l'intermédiaire du module d'interface 36, les valeurs $r_{FINi}$, $\Psi_{FINi}$, $\delta r_{FINi}$, $F^*A_{FINi}$ et $\varphi_{FINi}$, i variant de 1 à N.

Pour afficher l'évolution de la tension $V_i$ en fonction du temps, il est nécessaire de disposer des facteurs de proportionnalité $F_i$ pour chaque conducteur $12_i$. Les facteurs de proportionnalité $F_i$ peuvent être obtenus par une étape préalable de calibration du câble 10 et être stockée dans une mémoire non volatile du module de traitement 34. A titre d'exemple, une liste de facteurs de pondération peut être stockée dans la mémoire non volatile du module de traitement 34, chaque facteur de pondération correspondant à un type de câble d'alimentation particulier. L'opérateur peut alors sélectionner les valeurs des facteurs de proportionnalité $F_i$ en utilisant le module d'interface 36. Même si le facteur de proportionnalité $F_i$ n'est pas connu, le dispositif de mesure 20 fournit pour chaque conducteur $12_i$ un signal qui est proportionnel à la tension $V_i$. Ce signal peut alors être utilisé pour vérifier le bon fonctionnement du câble 10.

## EP 3 004 900 B1

**Revendications**

1. Procédé de mesure de la tension d'au moins un conducteur ($12_1$, $12_2$, $12_3$) d'un câble (10) d'alimentation électrique comprenant les étapes suivantes :

   disposer une enceinte (22) d'un matériau conducteur autour d'une portion du câble et au moins un capteur ($30_1$, $30_2$, $30_3$, $30_4$) de champ électrique entre l'enceinte et le câble ;
   amener l'enceinte à un potentiel constant et mesurer le champ électrique par le capteur ; et
   **caractérisé par** l'étape suivante :
   déterminer ladite tension à partir de la comparaison du champ électrique mesuré à des champs électriques simulés pour plusieurs configurations de charges électriques ponctuelles ($P_{1,1}$, $P_{1,2}$, $P'_{1,1}$, $P'_{1,2}$).

2. Procédé selon la revendication 1, comprenant, en outre, les étapes suivantes :

   déterminer par simulation le champ électrique obtenu à l'emplacement dudit capteur ($30_1$, $30_2$, $30_3$, $30_4$) pour plusieurs configurations de charges électriques ponctuelles ($P_{1,1}$, $P_{1,2}$, $P'_{1,1}$, $P'_{1,2}$) correspondant à des positions différentes des charges électriques ponctuelles ;
   déterminer un critère de comparaison entre le champ électrique mesuré et le champ électrique simulé pour chaque configuration ; et
   mémoriser la configuration pour laquelle le critère de comparaison est à un extrémum.

3. Procédé selon la revendication 2, comprenant la détermination par simulation du champ électrique obtenu à l'emplacement dudit capteur ($30_1$, $30_2$, $30_3$, $30_4$) pour chaque configuration d'un premier ensemble de configurations ayant un premier nombre de charges électriques ponctuelles ($P_{1,1}$, $P_{1,2}$, $P'_{1,1}$, $P'_{1,2}$) et pour chaque configuration d'un deuxième ensemble de configurations ayant un deuxième nombre de charges électriques ponctuelles différent du premier nombre.

4. Procédé selon la revendication 2 ou 3, comprenant les étapes suivantes :

   sélectionner au moins un paramètre parmi le groupe comprenant la position du centre ($O_1$, $O_2$, $O_3$) du conducteur ($12_1$, $12_2$, $12_3$) par rapport au centre du câble (10), le rayon moyen du conducteur, la position angulaire ($\Psi_1$, $\Psi_2$, $\Psi_3$) du conducteur par rapport à un axe de référence (OX), la phase ($\varphi_1$, $\varphi_2$, $\varphi_3$) de la tension du conducteur et l'amplitude maximale ($A_1$, $A_2$, $A_3$) de la tension du conducteur ;
   faire varier le paramètre entre une valeur initiale et une valeur finale avec un pas ; et
   déterminer le champ électrique obtenu à l'emplacement dudit capteur ($30_1$, $30_2$, $30_3$, $30_4$) pour chaque configuration de charges électriques ponctuelles ($P_{1,1}$, $P_{1,2}$, $P'_{1,1}$, $P'_{1,2}$) associée à chaque valeur du paramètre.

5. Procédé selon l'une quelconque des revendications 2 à 4, comprenant les étapes suivantes :

   (a) déterminer le nombre de conducteurs ($12_1$, $12_2$, $12_3$) du câble (10) à partir de la comparaison du champ électrique mesuré aux champs électriques simulés pour des configurations de charges électriques ponctuelles ($P_{1,1}$, $P_{1,2}$, $P'_{1,1}$, $P'_{1,2}$) comprenant des nombres différents de charges électriques ponctuelles ; et
   (b) déterminer ladite tension à partir de la comparaison du champ électrique mesuré aux champs électriques simulés pour plusieurs configurations ayant le même nombre de charges électriques ponctuelles.

6. Procédé selon les revendications 4 et 5, dans lequel l'étape (a) est réalisée en faisant varier, simultanément pour chaque conducteur, au moins un premier paramètre parmi ledit groupe et dans lequel l'étape (b) est réalisée en faisant varier, indépendamment pour chaque conducteur, au moins un deuxième paramètre parmi ledit groupe.

7. Dispositif (20) de mesure de la tension d'au moins un conducteur ($12_1$, $12_2$, $12_3$) d'un câble (10) d'alimentation électrique comprenant :

   une enceinte (22) d'un matériau conducteur destinée à être disposée autour d'une portion du câble et au moins un capteur ($30_1$, $30_2$, $30_3$, $30_4$) de champ électrique destiné à être disposé entre l'enceinte et le câble ;
   une source (34) d'un potentiel constant reliée à l'enceinte ; et
   **caractérisé par** un module de traitement (34) adapté à déterminer ladite tension à partir de la comparaison du champ électrique mesuré aux champs électriques simulés pour plusieurs configurations de charges électriques ponctuelles ($P_{1,1}$, $P_{1,2}$, $P'_{1,1}$, $P'_{1,2}$).

8. Dispositif selon la revendication 7, comprenant plusieurs capteurs ($30_1$, $30_2$, $30_3$, $30_4$) de champ électrique.

9. Dispositif selon la revendication 8, dans lequel les capteurs ($30_1$, $30_2$, $30_3$, $30_4$) sont maintenus dans un support (32) tubulaire d'un matériau diélectrique.

10. Dispositif selon l'une quelconque des revendications 7 à 9, comprenant au moins un capteur optique ($30_1$, $30_2$, $30_3$, $30_4$) mesurant le champ électrique comprenant un cristal électro-optique isotrope.

**Patentansprüche**

1. Verfahren zum Messen der Spannung von mindestens einem Leiter ($12_1$, $12_2$, $12_3$) eines elektrischen Stromkabels (10), das die folgenden Schritte aufweist:

Anordnen eines Gehäuses (22) aus einem leitenden Material um einen Abschnitt des Kabels und wenigstens einen elektrischen Feldsensor ($30_1$, $30_2$, $30_3$, $30_4$) zwischen dem Gehäuse und dem Kabel; Bringen des Gehäuses auf ein konstantes Potential und Messen des elektrischen Feldes mit dem Sensor; und **gekennzeichnet durch** den folgenden Schritt: Bestimmen der Spannung basierend auf dem Vergleich des gemessenen elektrischen Feldes mit simulierten elektrischen Feldern für eine Vielzahl von Konfigurationen von elektrischen Punktladungen ($P_{1,1}$, $P_{1,2}$, $P'_{1,1}$, $P'_{1,2}$).

2. Verfahren nach Anspruch 1, das ferner die folgenden Schritte aufweist:

Bestimmen, durch Simulation, des elektrischen Feldes, das an der Position des Sensors ($30_1$, $30_2$, $30_3$, $30_4$) erhalten wird für eine Vielzahl von Konfigurationen von elektrischen Punktladungen ($P_{1,1}$, $P_{1,2}$, $P'_{1,1}$, $P'_{1,2}$), welche verschiedenen Positionen der elektrischen Punktladungen entsprechen; Bestimmen eines Vergleichskriteriums zwischen dem elektrischen Feld und dem simulierten elektrischen Feld für jede Konfiguration; und Speichern der Konfiguration, bei der das Vergleichskriterium ein Extremum ist.

3. Verfahren nach Anspruch 2, umfassend das Bestimmen des elektrischen Feldes, das an der Position des Sensors ($30_1$, $30_2$, $30_3$, $30_4$) erhalten wird, durch Simulation für jede Konfiguration eines ersten Satzes von Konfigurationen mit einer ersten Anzahl von elektrischen Punktladungen ($P_{1,1}$, $P_{1,2}$, $P'_{1,1}$, $P'_{1,2}$) und für jede Konfiguration eines zweiten Satzes von Konfigurationen mit einer zweiten Anzahl von elektrischen Punktladungen, die sich von der ersten Zahl unterscheiden.

4. Verfahren nach Anspruch 2 oder 3, das die folgenden Schritte aufweist:

Auswählen wenigstens eines Parameters aus der Gruppe die folgendes aufweist die Position der Mitte ($O_1$, $O_2$, $O_3$) des Leiters ($12_1$, $12_2$, $12_3$) bezüglich der Mitte des Kabels (10), den durchschnittlichen Radius des Leiters, die Winkelposition ($\Psi_1$, $\Psi_2$, $\Psi_3$) des Leiters bezüglich einer Referenzachse (OX), die Phase ($\varphi_1$, $\varphi_2$, $\varphi_3$) der Spannung des Leiters und die maximale Amplitude ($A_1$, $A_2$, $A_3$) der Spannung des Leiters; Variieren des Parameters zwischen einem Anfangswert und einem Endwert mit einem Schritt; und Bestimmen, durch Simulation, des elektrischen Feldes, das an der Position des Sensors ($30_1$, $30_2$, $30_3$, $30_4$) erhalten wird, für jede Konfiguration von elektrischen Punktladungen ($P_{1,1}$, $P_{1,2}$, $P'_{1,1}$, $P'_{1,2}$), die mit jedem Wert des Parameters assoziiert sind.

5. Verfahren nach einem der Ansprüche 2 bis 4, das die folgenden Schritte aufweist:

(a) Bestimmen der Anzahl der Leiter ($12_1$, $12_2$, $12_3$) des Kabels (10) basierend auf dem Vergleich des gemessenen elektrischen Feldes mit den simulierten elektrischen Feldern für Konfigurationen von elektrischen Punktladungen ($P_{1,1}$, $P_{1,2}$, $P'_{1,1}$, $P'_{1,2}$), die unterschiedliche Anzahlen von elektrischen Punktladungen aufweisen; und (b) Bestimmen der Spannung basierend auf dem Vergleich des gemessenen elektrischen Feldes mit den simulierten elektrischen Feldern für eine Vielzahl von Konfigurationen mit der gleichen Anzahl von elektrischen Punktladungen.

6. Verfahren nach den Ansprüchen 4 und 5, wobei der Schritt (a) durchgeführt wird, indem gleichzeitig für jeden Leiter mindestens ein erster Parameter aus der Gruppe variiert wird, und wobei Schritt (b) ausgeführt wird, indem unabhängig für jeden Leiter mindestens ein zweiter Parameter aus der Gruppe variiert wird.

7. Vorrichtung (20) zum Messen der Spannung von wenigstens einem Leiter ($12_1$, $12_2$, $12_3$) eines elektrischen Stromkabels (10), aufweisend:

   ein Gehäuse (22) aus einem leitenden Material, das dazu bestimmt ist, um einen Abschnitt des Kabels herum angeordnet zu werden, und wenigstens einen elektrischen Feldsensor ($30_1$, $30_2$, $30_3$, $30_4$), der dazu bestimmt ist, zwischen dem Gehäuse und dem Kabel angeordnet zu werden;
   eine Quelle (34) eines konstanten Potentials, die mit dem Gehäuse verbunden ist; und
   **gekennzeichnet durch** eine Verarbeitungseinheit (34), die in der Lage ist, die Spannung basierend auf dem Vergleich des gemessenen elektrischen Feldes mit simulierten elektrischen Feldern für eine Vielzahl von Konfigurationen von elektrischen Punktladungen ($P_{1,1}$, $P_{1,2}$, $P'_{1,1}$, $P'_{1,2}$) zu bestimmen.

8. Vorrichtung nach Anspruch 7, aufweisend eine Vielzahl von elektrischen Feldsensoren ($30_1$, $30_2$, $30_3$, $30_4$).

9. Vorrichtung nach Anspruch 8, wobei die Sensoren ($30_1$, $30_2$, $30_3$, $30_4$) in einem rohrförmigen Träger (32) aus einem dielektrischen Material gehalten werden.

10. Vorrichtung nach einem der Ansprüche 7 bis 9, aufweisend wenigstens einen optischen Sensor ($30_1$, $30_2$, $30_3$, $30_4$), der das elektrische Feld misst, und einen isotropen elektro-optischen Kristall aufweist.


**Claims**

1. A method of measuring the voltage of at least one conductor ($12_1$, $12_2$, $12_3$) of an electric power cable (10) comprising the steps of:

   arranging an enclosure (22) of a conductive material around a portion of the cable and at least one electric field sensor ($30_1$, $30_2$, $30_3$, $30_4$) between the enclosure and the cable;
   taking the enclosure to a constant potential and measuring the electric field with the sensor; and
   **characterized by** the following step:
   determining said voltage based on the comparison of the measured electric field with simulated electric fields for a plurality of configurations of point electric charges ($P_{1,1}$, $P_{1,2}$, $P'_{1,1}$, $P'_{1,2}$).

2. The method of claim 1, further comprising the steps of:

   determining by simulation the electric field obtained at the location of said sensor ($30_1$, $30_2$, $30_3$, $30_4$) for a plurality of configurations of point electric charges ($P_{1,1}$, $P_{1,2}$, $P'_{1,1}$, $P'_{1,2}$) corresponding to different positions of the point electric charges;
   determining a criterion of comparison between the electric field and the simulated electric field for each configuration; and
   storing the configuration for which the comparison criterion is at an extremum.

3. The method of claim 2, comprising determining by simulation the electric field obtained at the location of said sensor ($30_1$, $30_2$, $30_3$, $30_4$) for each configuration of a first set of configurations having a first number of point electric charges ($P_{1,1}$, $P_{1,2}$, $P'_{1,1}$, $P'_{1,2}$) and for each configuration of a second set of configurations having a second number of point electric charges different from the first number.

4. The method of claim 2 or 3, comprising the steps of:

   selecting at least one parameter from the group comprising the position of the center ($O_1$, $O_2$, $O_3$) of the conductor ($12_1$, $12_2$, $12_3$) with respect to the center of the cable (10), the average radius of the conductor, the angular position ($\Psi_1$, $\Psi_2$, $\Psi_3$) of the conductor with respect to a reference axis (OX), the phase ($\varphi_1$, $\varphi_2$, $\varphi_3$) of the voltage of the conductor, and the maximum amplitude ($A_1$, $A_2$, $A_3$) of the voltage of the conductor;
   varying the parameter between an initial value and a final value with a step; and
   determining by simulation the electric field obtained at the location of said sensor ($30_1$, $30_2$, $30_3$, $30_4$) for each configuration of point electric charges ($P_{1,1}$, $P_{1,2}$, $P'_{1,1}$, $P'_{1,2}$) associated with each value of the parameter.

**5.** The method of any of claims 2 to 4, comprising the steps of:

(a) determining the number of conductors ($12_1$, $12_2$, $12_3$) of the cable (10) based on the comparison of the measured electric field with the simulated electric fields for configurations of point electric charges ($P_{1,1}$, $P_{1,2}$, $P'_{1,1}$, $P'_{1,2}$) comprising different numbers of point electric charges; and
(b) determining said voltage based on the comparison of the measured electric field with the simulated electric fields for a plurality of configurations having the same number of point electric charges.

**6.** The method of claims 4 and 5, wherein step (a) is carried out by varying, simultaneously for each conductor, at least one first parameter from said group and wherein step (b) is carried out by varying, independently for each conductor, at least one second parameter from said group.

**7.** A device (20) for measuring the voltage of at least one conductor ($12_1$, $12_2$, $12_3$) of an electric power cable (10) comprising:

an enclosure (22) of a conductive material intended to be arranged around a portion of the cable and at least one electric field sensor ($30_1$, $30_2$, $30_3$, $30_4$) intended to be arranged between the enclosure and the cable;
a source (34) of a constant potential connected to the enclosure; and
**characterized by** a processing unit (34) capable of determining said voltage based on the comparison of the measured electric field with the simulated electric fields for a plurality of configurations of point electric charges ($P_{1,1}$, $P_{1,2}$, $P'_{1,1}$, $P'_{1,2}$)

**8.** The device of claim 7, comprising a plurality of electric field sensors ($30_1$, $30_2$, $30_3$, $30_4$).

**9.** The device of claim 8, wherein the sensors ($30_1$, $30_2$, $30_3$, $30_4$) are maintained in a tubular support (32) of a dielectric material.

**10.** The device of any of claims 7 to 9, comprising at least one optical sensor ($30_1$, $30_2$, $30_3$, $30_4$) measuring the electric field comprising an isotropic electro-optical crystal.

Fig 1

Module de Traitement

Module d'Interface

Fig 2

Fig 3

Fig 4

```
┌─────────────────────────┐
│     Mise en place       │ ⌐40
│       Capteur           │
└────────────┬────────────┘
             │
             ▼
┌─────────────────────────┐
│     Mesure Champ        │ ⌐42
│      Electrique         │
└────────────┬────────────┘
             │
             ▼
┌─────────────────────────┐
│   Détection Nombre      │ ⌐44
│    de Conducteurs       │
└────────────┬────────────┘
             │
             ▼
┌─────────────────────────┐
│  Détection Paramètres   │ ⌐46
│   r , ψ , φ , A_i/F     │
└─────────────────────────┘
```

Fig 5

$\vec{E_1}$ — 50
52
$C_1$

$\vec{E_4}$   $12_2$   $12_1$   $\vec{E_2}$
$C_4$                          $C_2$
              $12_3$
          $\vec{E_3}$
              $C_3$

Fig 6

54

$12_1$
$P_1$

Fig 7

Fig 8

Fig 9

Fig 10

Fig 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1354984
- WO 0034793 A1
- US 5473244 A
- WO P011117598 X
- US 8264685 B

**Littérature non-brevet citée dans la description**

- **A. RONCIN ; C. SHAFAI ; D.R. SWATEK.** *Electric field sensor using electrostatic force deflection of a micro-spring supported membrane*
- **T. DENISON ; J. KUANG ; J. SHAFRAN ; M. JUDY ; K. LUNDBERG.** *A Self-Resonant MEMS-based Electrostatic Field Sensor with 4V/m/√Hz Sensitivity*